# DEMANDE DE BREVET EUROPEEN

(11) **EP 2 208 543 A1**
(43) Date de publication de la demande: **21.07.2010**
(21) Numéro de dépôt: 09306218.0
(22) Date de dépôt: 11.12.2009
(51) Int. Cl.: B05D 5/00, B05D 7/00

(54) **Procédé de dépôt d'un matériau à la surface d'un objet**

(30) Priorité: 19.01.2009 FR 0950301
(71) Demandeur: Commissariat à l'Énergie Atomique et aux Énergies Alternatives, 75015 Paris (FR)
(72) Inventeur: Benwadih, Mohamed, 38000 GRENOBLE (FR); Heitzmann, Marie, 38650 SINARD (FR); Verilhac, Jean-Marie, 38000 GRENOBLE (FR)
(74) Mandataire: Vuillermoz, Bruno

(57) **Abrégé**

L'invention concerne un procédé de dépôt d'une couche de matériau (18) à la surface d'un objet (12), du type comportant le dépôt d'une couche de solution (16) dudit matériau dans un premier liquide suivi de l'évaporation du premier liquide pour former la couche de matériau (18).

Selon l'invention, le procédé comporte la formation d'une couche (14) d'un second liquide interposée entre l'objet (12) et la couche de solution (16), le second liquide étant non miscible avec le premier liquide, de densité supérieure à celle du premier liquide et de température d'évaporation supérieure à celle du premier liquide.

## Description

### DOMAINE DE L'INVENTION

L'invention a trait au domaine de l'électronique, et plus particulièrement au domaine du dépôt, notamment par voie liquide, d'un matériau à la surface d'un objet, tel qu'un substrat par exemple. L'invention trouve tout particulièrement application dans le dépôt de matériaux organiques par voie liquide, mais elle peut également s'appliquer au dépôt de matériaux inorganiques.

### ETAT DE LA TECHNIQUE

La microélectronique s'est classiquement développée autour de matériaux inorganiques tel que le silicium (Si) ou l'arséniure de galium (GaAs). Une autre voie est aujourd'hui explorée autour des matériaux organiques, tels que les polymères, en raison de leur facilité de fabrication à grande échelle, de leur tenue mécanique, de leur structure flexible ou encore de leur facilité de retraitement. Il a ainsi été conçu des écrans à base de diodes organiques (les OLED) ou à base de transistors organiques à couche mince (les OTFT). En outre, l'utilisation de techniques de dépôt de couche, par exemple par tournette (« *spin-coating* »), par jet d'encre ou par sérigraphie, est rendue possible par l'utilisation de polymères solubles.

Cependant le dépôt de matériau organique présente un certain nombre de difficultés. Plus particulièrement, l'obtention d'une couche organique conductrice de bonne qualité à la surface d'un substrat est difficile. En effet, une couche organique conductrice est obtenue à l'aide de matériaux organiques cristallins. Ces derniers présentent, à la différence des matériaux amorphes dont l'organisation moléculaire est aléatoire, impliquant ainsi un transport électronique difficile et donc une mauvaise conduction électrique, une structure moléculaire périodique permettant une conduction électrique fiable et contrôlée.

Toutefois, en étudiant les propriétés électriques d'une couche mince de polymère cristallin déposée, par exemple par voie liquide, à la surface d'un substrat, il est généralement observé une conduction chaotique et imprévisible du courant électrique au lieu de présenter la bonne conductivité électrique attendue.

En effet, les techniques usuelles de formation d'une couche de matériau organique (usuellement le dépôt d'une solution comportant ledit matériau dilué dans un solvant, suivi de l'évaporation du solvant menant à la formation d'une couche de matériau cristallisé) ne permettent généralement pas une croissance homogène du réseau cristallin en raison de la non-homogénéité de la surface du substrat. Par exemple, la surface du substrat présente des rugosités, une énergie de surface non homogène, des marches ou encore des éléments fonctionnels tels que des connexions métalliques par exemple.

En outre, les matériaux organiques non cristallins posent également des problèmes lors de leur dépôt également en raison de la non homogénéité de la surface du substrat, comme des problème de rupture de mouillabilité ou de passage de marche.

### EXPOSE DE L'INVENTION

Le but de la présente invention est de résoudre les problèmes susmentionnés en proposant un procédé de dépôt d'une couche de matériau, organique ou non, à la surface d'un objet, notamment un substrat, dont la qualité est sensiblement indépendante de l'état de surface de l'objet.

A cet effet l'invention a pour objet de dépôt d'une couche de matériau à la surface d'un objet, du type comportant le dépôt d'une couche de solution dudit matériau dans un premier liquide, suivi de l'évaporation du premier liquide pour former la couche de matériau.

Selon l'invention, le procédé comporte la formation d'une couche d'un second liquide interposée entre l'objet et la couche de solution, le second liquide étant non miscible avec le premier liquide, de densité supérieure à celle du premier liquide, et de température d'évaporation supérieure à celle du premier liquide.

Par solution, on entend notamment soit une dissolution du matériau dans un solvant, soit une dispersion de nano-objets dans un dispersant.

En d'autres termes, la solution constituée du matériau et du premier liquide est formée à la surface d'un « tapis » du second liquide, ce tapis étant quant à lui déposé sur la surface de l'objet. Du fait de la non miscibilité des premier et second liquides, l'interface entre les deux liquides présente une surface homogène, cette homogénéité étant indépendante de l'état de surface de l'objet. Si ladite surface n'est pas parfaitement homogène, on notera toutefois que sa non-uniformité est de l'ordre moléculaire, dimension non accessible avec les techniques actuelles. On notera ainsi que la surface du substrat peut présenter de grandes disparités énergétiques (par exemple induites par la présence de matériaux distincts) ou géométriques (rugosités, marches, poussières, etc...) sans que cela ait une incidence directe sur la qualité du cristal formé à la surface de l'objet lorsqu'il y a cristallisation ou tout simplement sur la qualité du dépôt réalisé.

Une telle homogénéité est en outre appropriée à la croissance homogène du cristal d'un matériau organique cristallin lors de l'évaporation du premier liquide. Un réseau cristallin de grande homogénéité est ainsi obtenu à la surface de l'objet après évaporation du second liquide.

Selon des modes de réalisations de l'invention, le procédé comporte une ou plusieurs des caractéristiques suivantes.

Ainsi, le matériau que l'on souhaite déposer n'est pas soluble dans le second liquide.

La formation de la couche du second liquide est réalisée par le dépôt de celle-ci sur l'objet préalablement au dépôt de la couche de solution.

Un mélange, comportant le matériau et les premier et second liquides, est déposé à la surface de l'objet, la formation de la couche du second liquide étant réalisée par démixion et séparation de phase.

Le second liquide est plus dense que le premier liquide d'au moins 0,2 mg/l.

La température d'évaporation du second liquide est supérieure à la température d'évaporation du premier liquide d'au moins 20 degrés.

La solution comprend le matériau dissout dans un solvant. Plus particulièrement, le solvant est du toluène et le second liquide est un liquide fluoré, ou bien le solvant est du toluène et le second liquide est de l'eau.

La solution comprend le matériau sous forme de nano-objets dispersés dans un dispersant. Notamment, les nano-objets sont des nanofils ou des nanotubes, le dispersant et de l'alcool et le second liquide est un liquide fluoré.

### BREVE DESCRIPTION DES FIGURES

L'invention sera mieux comprise à la lecture de la description qui va suivre, donnée uniquement à titre d'exemple, et réalisée en relation avec les dessins annexés dans lesquels :
- les figures 1 à 4 sont des vues schématiques en section illustrant des étapes d'un procédé de dépôt sur une surface globalement plane selon l'invention ;
- la figure 5 illustre un défaut de passage de marche de l'état de la technique ;
- les figures 6 et 7 illustrent la manière dont l'invention résout de tels défauts de passage de marche ;
- la figure 8 illustre un défaut de mouillabilité de l'état de la technique produit par la présence de défaut de surface ; et
- les figures 9 et 10 illustrent la manière dont l'invention résout de tels défauts de mouillabilité.

### DESCRIPTION DETAILLEE DE L'INVENTION

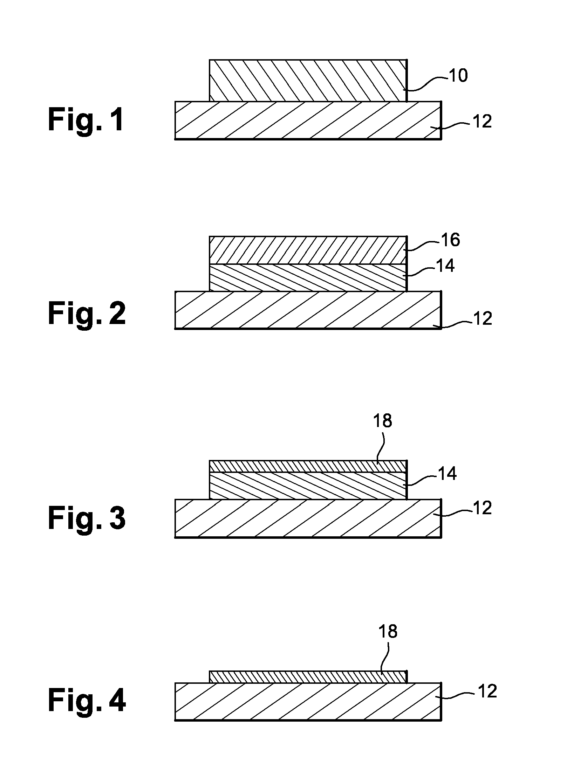

Il va être décrit à l'aide des figures 1 à 4 un procédé de dépôt d'une couche de matériau selon l'invention.

Lors d'une première étape, un mélange **10,** comportant un premier et un second liquides ainsi qu'un matériau à déposer, est déposé par voie liquide à la surface d'un substrat **12** (figure 1).

Le mélange **10** est par exemple préparé en mélangeant une première solution, comportant le matériau solubilisé dans le premier liquide, et le second liquide, ce dernier ne solubilisant par le matériau.

De plus, le second liquide est choisi pour être non miscible avec le premier liquide et plus dense que celui-ci, de sorte qu'un processus de démixion et de séparation de phase se produit. Le second liquide prend alors la forme d'une couche **14** à la surface du substrat **12,** le premier liquide et le matériau prenant alors quant à eux la forme d'une couche **16** à la surface de la couche **14** du second liquide (figure 2).

Par ailleurs, le second liquide est également sélectionné pour présenter une température d'évaporation supérieure à celle du premier liquide de sorte que, lors de l'évaporation du premier liquide, le second liquide ne s'évapore pas.

De manière analogue, le mélange **10** est par exemple préparé en mélangeant des nano-objets à un premier dispersant et au second liquide, ce dernier ne créant pas une seule phase avec le premier dispersant.

Ainsi, une fois le processus de démixion et de séparation de phase achevé, le procédé selon l'invention se poursuit par le chauffage de l'ensemble formé du substrat **12** et des couches **14** et **16** à une température supérieure ou égale à la température d'évaporation du premier liquide et inférieure à la température d'évaporation du second liquide. Lors de cette évaporation, le matériau contenu dans la couche **16** se dépose et une couche de matériau **18** est ainsi finalement obtenue à la surface de la couche **14** du second liquide (figure 3). Si le matériau est propre à se cristalliser, il est alors obtenue une couche de matériau cristallisé.

Une fois, la couche **18** obtenue, une seconde phase de chauffage est réalisée en portant l'ensemble formé du substrat **12** et des couches **14** et **18** à une température supérieure ou égale à la température d'évaporation du second liquide. La couche **14** du second liquide s'évapore alors de sorte que la couche **18** de matériau est déposée à la surface du substrat **12** et, le cas échant, finit de sécher (figure 4).

En variante, plutôt que de déposer un mélange **10** comportant à la fois le matériau et les premier et second liquides, une couche du second liquide est déposée sur la surface du substrat **12,** puis une couche de solution comportant le matériau organique et le premier substrat est déposée sur la couche liquide du second liquide.

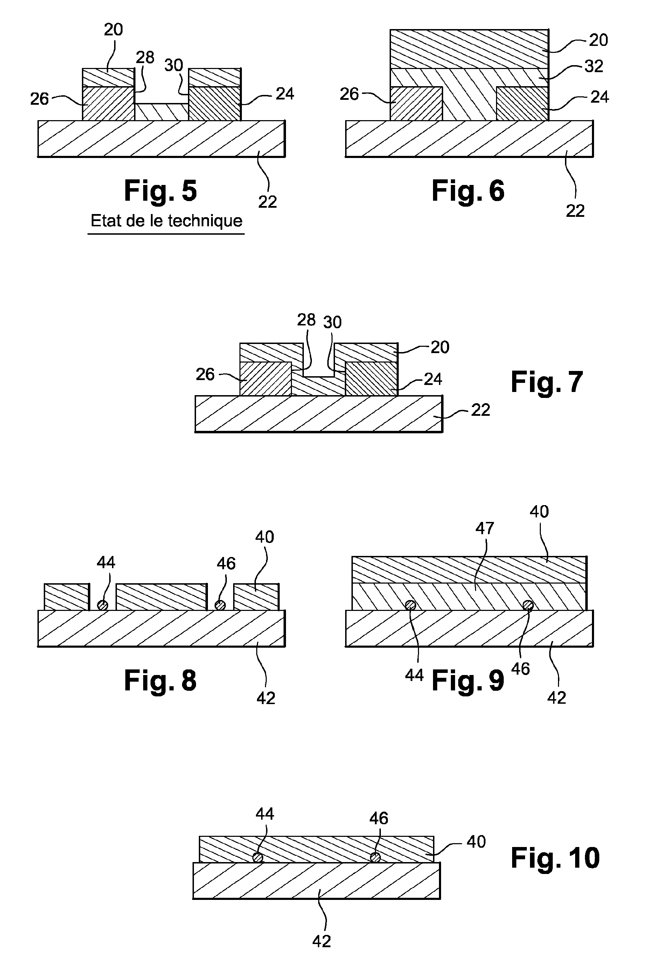

La figure 5 illustre un cas fréquent de difficultés rencontrées dans l'état de la technique lors du dépôt d'une couche **20** de solution d'un matériau, cristallin ou amorphe, sur un substrat **22** comportant des éléments **24, 26** formant saillies à la surface de celui-ci. Usuellement, en évaporant le solvant de la solution, il apparaît des ruptures du dépôt au niveau des passages de marche **28, 30.**

Selon l'invention, une couche **32** d'un second liquide, non miscible et plus dense que le premier liquide, est déposée, comblant l'espace entre le substrat **22** et la couche **20** de manière à englober les éléments **24, 26** (figure 6), comme cela a été décrit précédemment. Ensuite, en faisant évaporer successivement le premier liquide et le second liquide, qui présente une température d'évaporation supérieure à celle du premier liquide, on obtient une couche **20** de matériau ne présentant pas de rupture au niveau des passages de marche **28, 30.** En effet, lorsque la couche de matériau organique **20** s'affaisse en raison de l'évaporation de la couche **24** du second liquide, elle est déjà sensiblement sèche de sorte qu'elle ne rompt pas.

La figure 8 illustre un autre cas fréquent de difficultés rencontrées dans l'état de la technique lors d'un dépôt direct d'une solution **40** de matériau dans un solvant sur la surface d'un substrat **42.** Lorsque cette surface comporte des imperfections **44, 46,** comme des poussières ou des rugosités par exemple, la couche **40** de solution démouille au niveau de celle-ci. Ce type de défauts est particulièrement sensible lorsque la couche de matériau remplit une fonction d'isolant électrique car il en résulte une augmentation des courants de fuite, et d'une manière générale une diminution des performances électriques.

En formant une couche **47** de second liquide entre le substrat **42** et la couche **40** (figure 9), puis en procédant à l'évaporation successive du premier et du second liquides, il est ainsi obtenu une couche de matériau dans laquelle les défauts de surface **44, 46** sont enfouis (figure 10).

Selon l'invention, le second liquide est non miscible avec le premier liquide, est plus dense que celui-ci et présente une température d'évaporation supérieure.

De préférence, le second liquide est plus dense de 0,2 mg/l que le premier liquide et présente une température d'évaporation supérieure à celle du premier liquide d'au moins 20°C. En deçà de ces valeurs, les inventeurs ont observé que la qualité du dépôt du matériau à la surface du substrat se dégrade sensiblement.

De préférence, le premier liquide est du toluène et le second liquide est un liquide fluoré, préférentiellement du perfluoropolymère, ou bien le premier liquide est du toluène et le second liquide est de l'eau. Les inventeurs ont en effet constaté que ces combinaisons permettent la formation d'un « tapis » de qualité pour le matériau à déposer et la formation d'une couche de matériau de qualité, notamment lorsque celui-ci est du type semi-conducteur.

Les premier et second liquides peuvent toutefois être choisis en fonction de l'application visée parmi:
■ les solvants conducteurs, tels que par exemple la polyaniline dopée, du polyéthylène dioxythiophène - polystyrène sulfanate (PDOT- PSS) dopé, de l'oxyde d'indium et d'étain (ITO) ou des encres, c'est-à-dire des nanoparticules de métal, comme par exemple l'argent, dans un solvant, tel que l'éthylène glycol ;
■ les solvants semi-conducteurs, tels que par exemple la polyaniline, du PDOT-PSS, du pentacène modifié (TIPS), les polythiophènes (par exemple du poly-3-hexylthiophène (P3HT)) ou les polyacétylènes ;
■ les solvants diélectriques, tel que par exemple le polyvinylphénol (PVP), le polyméthyle méthacrylate (PMMA), le méthylsilsesquiexane (PMMSQ), le polyimide, les fluoropolymères (PVDF) ou les perfluoropolymères (PTFE) ;
■ les solvants polaires, tels que par exemple l'héxane, le benzène, le toluène, le diéthyl éther, le chloroforme, ou l'acétate d' éthyle ;
■ les solvants polaires aprotiques, tel que par exemple le 1-4 dioxane, le tétrahydrofurane (THF), le dichlorométhane (DCM) ou l'acétone ;
■ les dispersants pour nano-objets (par exemple des nanofils de silicium, des nanotubes de carbone ou des nanoparticules), tels que l'eau ou l'alcool.

Grâce à l'invention, il est ainsi obtenu notamment les avantages suivants :
■ une indépendance de la formation de la couche de matériau vis-à-vis de la surface sur laquelle elle est déposée. Cette surface, appartenant à un objet quelconque, comme un substrat en métal ou en plastique par exemple, peut ainsi présenter une non uniformité comme des variations d'énergie, des rugosités, des poussières ou des éléments formant saillie ; et
■ lorsque le matériau doit se cristalliser dans le but d'obtenir une couche cristalline de bonne qualité électrique, une surface de cristallisation homogène formée par l'interface entre les liquides non miscibles.

## Revendications

1. Procédé de dépôt d'une couche de matériau (18) à la surface d'un objet (12), du type comportant le dépôt d'une couche de solution (16) dudit matériau dans un premier liquide, suivi de l'évaporation du premier liquide pour former la couche de matériau (18), ***caractérisé* en ce qu'**il comporte la formation d'une couche (14) d'un second liquide interposée entre l'objet (12) et la couche de solution (16), le second liquide étant non miscible avec le premier liquide, de densité supérieure à celle du premier liquide et de température d'évaporation supérieure à celle du premier liquide.

2. Procédé selon la revendication 1, ***caractérisé* en ce que** le matériau (18) n'est pas soluble dans le second liquide.

3. Procédé selon l'une des revendications 1 et 2, ***caractérisé* en ce que** la formation de la couche (14) du second liquide est réalisée par le dépôt de celle-ci sur l'objet (12) préalablement au dépôt de la couche de solution (16).

4. Procédé selon l'une des revendications 1 et 2, ***caractérisé* en ce qu'**un mélange (10), comportant le matériau organique et les premier et second liquides, est déposé à la surface de l'objet (12), la formation de la couche (14) du second liquide étant réalisée par démixion et séparation de phase.

5. Procédé selon l'une quelconque des revendications précédentes, ***caractérisé* en ce que** le second liquide est plus dense que le premier liquide d'au moins 0,2 mg/l.

6. Procédé selon l'une quelconque des revendications précédentes, ***caractérisé* en ce que** la température d'évaporation du second liquide est supérieure à la température d'évaporation du premier liquide d'au moins 20 degrés.

7. Procédé selon l'une quelconque des revendications précédentes, ***caractérisé* en ce que** la solution comprend le matériau dissout dans un solvant.

8. Procédé selon la revendication 7, ***caractérisé* en ce que** le solvant est du toluène et **en ce que** le second liquide est un liquide fluoré.

9. Procédé selon la revendication 7, ***caractérisé* en ce que** le solvant est du toluène et **en ce que** le second liquide est de l'eau.

10. Procédé selon l'une quelconque des revendications 1 à 6, ***caractérisé* en ce que** la solution comprend le matériau sous la forme de nano-objets dispersés dans un dispersant.

11. Procédé selon la revendication 10, ***caractérisé* en ce que** les nano-objets sont des nanofils ou des nanotubes, **en ce que** le dispersant est de l'alcool, et **en ce que** le second liquide est un liquide fluoré.
